(19) Europäisches Patentamt
European Patent Office
Office européen des brevets

(11) EP 4 438 661 A1

(12) # EUROPEAN PATENT APPLICATION
published in accordance with Art. 153(4) EPC

(43) Date of publication:
**02.10.2024 Bulletin 2024/40**

(21) Application number: **22916232.6**

(22) Date of filing: **27.04.2022**

(51) International Patent Classification (IPC):
***C08J 5/18*** *(2006.01)* ***C08G 73/14*** *(2006.01)*
***C08L 79/08*** *(2006.01)* ***G02B 1/04*** *(2006.01)*

(52) Cooperative Patent Classification (CPC):
**C08G 73/14; C08J 5/18; C08L 79/08; G02B 1/04**

(86) International application number:
**PCT/KR2022/005983**

(87) International publication number:
**WO 2023/128075 (06.07.2023 Gazette 2023/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.12.2021 KR 20210193805**
**04.04.2022 KR 20220041859**

(71) Applicant: **Kolon Industries, Inc.**
**Seoul 07793 (KR)**

(72) Inventors:
- **PARK, Hyo Jun**
**Seoul 07793 (KR)**
- **JUNG, Hak-Gee**
**Seoul 07793 (KR)**

(74) Representative: **Ter Meer Steinmeister & Partner**
**Patentanwälte mbB**
**Nymphenburger Straße 4**
**80335 München (DE)**

(54) **OPTICAL FILM AND METHOD OF PREPARING SAME**

(57) The present invention relates to an optical film and a method of preparing same, the optical film comprising a polymer resin comprising imide repeating units and amide repeating units, the amide repeating units being included at a ratio of at least 80% relative to the imide repeating units and the amide repeating units.

FIG. 1

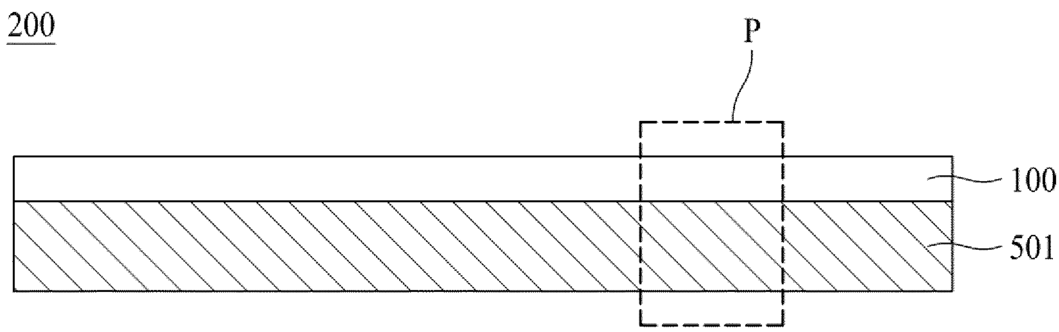


EP 4 438 661 A1

## Description

[Technical Field]

The present disclosure relates to an optical film including a high proportion of amide repeating units, and a method for manufacturing the same.

[Background Art]

Recently, the use of an optical film instead of glass as a cover window of a display device has been considered with the goal of reducing the thickness and weight of the display device and increasing the flexibility thereof. In order for the optical film to be usable as a cover window of a display device, the optical film needs to have excellent optical and mechanical properties. Therefore, it is necessary to develop an optical film that maintains optical properties even when used under external environments for a long period of time.

[Disclosure]

[Technical Problem]

It is one aspect of the present disclosure to provide an optical film that has a high degree of polymerization degree and contains a high proportion of amide repeating units.

It is another aspect of the present disclosure to provide an optical film that has a high degree of polymerization and includes a high proportion of amide repeating units and thereby exhibits excellent optical properties and mechanical properties.

It is another aspect of the present disclosure to provide a method for manufacturing an optical film that has a high degree of polymerization and includes a high proportion of amide repeating units.

[Technical Solution]

In accordance with the present disclosure, the above and other objects can be accomplished by the provision of an optical film containing a polymer resin including an imide repeating unit and an amide repeating unit, wherein the imide repeating unit is present in a proportion of 80% or more with respect to the total amount of the imide repeating unit and the amide repeating unit.

The optical film may contain 120 ppm by weight (0.012% by weight) or less of chlorine (Cl). The concentration of chlorine is measured by performing ion chromatography analysis on a chlorine (Cl) extract obtained by freeze-drying and pulverizing the optical film and then extracting the film using distilled water.

The optical film may contain 50 ppm by weight (0.005% by weight) or less of chlorine (Cl).

The imide repeating unit may include a first repeating unit and a second repeating unit, wherein the first repeating unit is an imide repeating unit formed by polymerization of a first diamine-based compound and a dianhydride-based compound, and the second repeating unit is an imide repeating unit formed by polymerization of a second diamine-based compound and the dianhydride-based compound.

The amide repeating unit may include a third repeating unit and a fourth repeating unit, wherein the third repeating unit is an amide repeating unit formed by polymerization of a first diamine-based compound and a dicarbonyl-based compound, and the fourth repeating unit is an amide repeating unit formed by polymerization of a second diamine-based compound and the dicarbonyl-based compound.

The first diamine-based compound may be an aromatic diamine-based compound, and the first diamine-based compound may include at least one selected from the group consisting of 2,2'-bis(trifluoromethyl)benzidine (TFDB), 2,2-bis[4-(4-aminophenoxy)phenyl]hexafluoropropane (HFBAPP), bis[4-(4-aminophenoxy)phenyl]sulfone (BAPS), bis[4-(3-minophenoxy)phenyl]sulfone (BAPSM), 4,4'-diaminodiphenylsulfone (4DDS), 3,3'-diaminodiphenylsulfone (3DDS), para-phenylene diamine (pPDA), meta-phenylene diamine (mPDA), para-methylene dianiline (pMDA), meta-methylene dianiline (mMDA), 2,2-bis[4-(4-aminophenoxy)phenyl] propane (BAPP), 4,4'-diaminodiphenyl propane (6HDA), 1,3-bis(4-aminophenoxy)benzene (134APB), 1,3-bis(3-aminophenoxy)benzene (133APB), 1,4-bis(4-aminophenoxy)biphenyl (BAPB), 4,4'-bis(4-amino-2-trifluoromethylphenoxy)biphenyl (6FAPBP), 3,3-diamino-4,4'-dihydroxydiphenylsulfone (DABS), 2,2-bis(3-amino-4-hydroxyphenyl)propane (BAP), 4,4'-diaminodiphenylmethane (DDM), 4,4'-oxydianiline (4-ODA), 3,3'-oxydianiline (3-ODA), 2,2'-dimethyl-4,4'-(9-fluorenylidene)dianiline (MFDA), 9,9-bis(4-aminophenyl)fluorene (FDA) and 9,9-bis(3-fluoro-4-aminophenyl)fluorene (FFDA).

The second diamine-based compound may be an aliphatic diamine-based compound, and the second diamine-based compound may include at least one selected from the group consisting of 4,4'-methylenebis cyclohexylamine

(MBCA), 1,3-bis(aminomethyl)cyclohexane, 1,4-cyclohexanediamine, bicyclo[2.2.1]heptanebis(methylamine), and isomers of cis, trans and mixtures of the compounds.

The dianhydride-based compound may include at least one selected from the group consisting of 2,2-bis(3,4-dicarboxyphenyl)hexafluoropropane dianhydride (6FDA), 4-(2,5-dioxotetrahydrofuran-3-yl)-1,2,3,4-tetrahydronaphthalene-1,2-dicarboxylic anhydride (TDA), 1,2,4,5-benzene tetracarboxylic dianhydride (pyromellitic dianhydride, PMDA), 3,3,4,4-benzophenone tetracarboxylic dianhydride (BTDA), 3,3,4,4-biphenyltetracarboxylic dianhydride (BPDA), 4,4-oxydiphthalic dianhydride (ODPA), bis(3,4-dicarboxyphenyl)dimethylsilane dianhydride (SiDA), 4,4-bis(3,4-dicarboxyphenoxy)diphenyl sulfide dianhydride (BDSDA), sulfonyldiphthalic anhydride ($SO_2DPA$), cyclobutane-1,2,3,4-tetracarboxylic dianhydride (CBDA), and 4,4'-(4,4'-isopropylidenediphenoxy)bis(phthalic anhydride) (6HBDA).

The dicarbonyl-based compound may include at least one selected from the group consisting of phthaloyl chloride, terephthaloyl chloride (TPC), isophthaloyl chloride (IPC), 4,4'-biphenyldicarbonyl chloride (DPDOC), 4,4'-oxybis(benzoyl chloride) (OBBOC), and naphthalene-2,3-dicarbonyl dichloride.

The optical film may have a yellowness index of 4.0 or less.

The optical film may have a light transmittance of 88.50% or more.

In accordance with another aspect of the present disclosure, there is provided a display device including a display panel and the optical film disposed on the display panel.

In accordance with another aspect of the present disclosure, there is provided a method for manufacturing an optical film, the method including forming a first reaction solution using at least one of a first diamine-based compound and a second diamine-based compound, a dianhydride-based compound, a dicarbonyl-based compound and a chlorine (Cl) acceptor, adding a dehydrating agent and an imidization catalyst to the first reaction solution and allowing a reaction to occur therebetween to form a second reaction solution, treating the second reaction solution to prepare a polymer resin in a solid phase, dissolving the solid-phase polymer resin to prepare a polymer resin solution, and casting the polymer resin solution, wherein a content of the chlorine (Cl) acceptor is 4 to 7 times the content of the dicarbonyl-based compound, based on the number of moles.

The first diamine-based compound may be an aromatic diamine-based compound, and the second diamine-based compound may be an aliphatic diamine-based compound.

With respect to 100 parts by mole of the total content of the first diamine-based compound and the second diamine-based compound, the content of the dicarbonyl-based compound may be 80 to 99 parts by mole, and the content of the dianhydride-based compound may be 1 to 20 parts by mole.

With respect to 100 parts by mole of the total content of the first diamine-based compound and the second diamine-based compound, the content of the first diamine-based compound may be 85 to 95 parts by mole and the content of the second diamine-based compound may be 5 to 15 parts by mole.

The chlorine (Cl) acceptor may include a cyclic ether-based compound.

The cyclic ether-based compound may include an epoxide-based compound, an oxetane-based compound, a tetrahydrofuran-based compound, and a tetrahydropyran-based compound.

The cyclic ether-based compound may include a propylene oxide-based compound.

The pH of the second reaction solution may be 8 to 9.

The pH of the polymer resin solution may be 6 to 7.

[Advantageous Effects]

According to an embodiment of the present disclosure, it is possible to provide a polymer resin having a high degree of polymerization even if a large amount of dicarbonyl-based compound is added by promoting the polymerization of a dicarbonyl-based compound.

According to an embodiment of the present disclosure, it is possible to provide a polymer resin having a high degree of polymerization by promoting the polymerization of an aliphatic diamine-based compound.

According to another embodiment of the present disclosure, it is possible to provide an optical film having excellent mechanical and optical properties.

According to another embodiment of the present disclosure, it is possible to provide an optical film including a high proportion of amide repeating units.

The optical film according to another embodiment of the present disclosure has excellent optical and mechanical properties and thus is capable of effectively protecting the display surface of a display device when used as a cover window of the display device.

[Description of Drawings]

FIG. 1 is a cross-sectional view illustrating a part of a display device according to an embodiment of the present disclosure; and

FIG. 2 is an enlarged cross-sectional view illustrating "P" of FIG. 1.

[Best Mode]

Hereinafter, embodiments of the present disclosure will be described in detail with reference to the accompanying drawings. However, the following embodiments are illustratively provided merely for clear understanding of the present disclosure, and do not limit the scope of the present disclosure.

The shapes, sizes, ratios, angles, and numbers disclosed in the drawings for describing embodiments of the present disclosure are merely examples, and the present disclosure is not limited to the illustrated details. Like reference numerals refer to like elements throughout the present specification. In the following description, when a detailed description of relevant known functions or configurations is determined to unnecessarily obscure important points of the present disclosure, the detailed description will be omitted.

In the case in which a term such as "comprise", "have", or "include" is used in the present specification, another part may also be present, unless "only" is also used. Terms in a singular form may include the plural meanings, unless noted to the contrary. Also, in construing an element, the element is to be construed as including an error range, even if there is no explicit description thereof.

In describing a positional relationship, for example, when the positional relationship is described using "on", "above", "below", or "next to", the case of no contact therebetween may be included, unless "just" or "directly" is used.

Spatially relative terms, such as "below", "beneath", "lower", "above", and "upper", may be used herein to describe the relationship between a device or element and another device or element, as shown in the figures. It will be understood that spatially relative terms are intended to encompass different orientations of a device during the use or operation of the device, in addition to the orientation depicted in the figures. For example, if a device in one of the figures is turned upside down, elements described as "below" or "beneath" other elements would then be positioned "above" the other elements. The exemplary term "below" or "beneath" can, therefore, encompass the meanings of both "below" and "above". In the same manner, the exemplary term "above" or "upper" can encompass the meanings of both "above" and "below".

In describing temporal relationships, for example, when a temporal order is described using "after", "subsequent", "next", or "before", the case of a non-continuous relationship may be included, unless "just" or "directly" is used.

It will be understood that, although the terms "first", "second", etc. may be used herein to describe various elements, these elements are not limited by these terms. These terms are only used to distinguish one element from another. Therefore, a first element could be termed a second element within the technical idea of the present disclosure.

It should be understood that the term "at least one" includes all combinations related with one or more items. For example, "at least one among a first element, a second element, and a third element" may include all combinations of two or more elements selected from among the first, second, and third elements, as well as each of the first, second, and third elements.

Features of various embodiments of the present disclosure may be partially or completely integrated or combined with each other, and may be variously interoperated with each other and driven technically. The embodiments of the present disclosure may be carried out independently from each other, or may be carried out together in an interrelated manner.

An embodiment of the present disclosure provides an optical film. The optical film according to the embodiment of the present disclosure contains a polymer resin.

The polymer resin may be contained in the film in any one of various shapes and forms, for example, as a solid powder, in the state of being dissolved in a solution, or as a matrix solidified after having been dissolved in a solution. Any resin may be considered as the same as the polymer resin of the present disclosure, regardless of the shape and form thereof, as long as it is a resin containing the same repeating unit as in the present disclosure. In general, the polymer resin may exist in the film in the form of a matrix, obtained by applying a polymer resin solution and drying the same to form a solid.

The polymer resin according to an embodiment of the present disclosure includes an imide repeating unit and an amide repeating unit. Accordingly, the optical film according to an embodiment of the present disclosure includes an imide repeating unit and an amide repeating unit.

According to an embodiment of the present disclosure, the imide repeating unit may include a first repeating unit and a second repeating unit, wherein the first repeating unit is an imide repeating unit formed by polymerization of a first diamine-based compound and a dianhydride-based compound and the second repeating unit is an imide repeating unit formed by polymerization of a second diamine-based compound and the dianhydride-based compound.

According to an embodiment of the present disclosure, the amide repeating unit may include a third repeating unit and a fourth repeating unit, wherein the third repeating unit is an amide repeating unit formed by polymerization of

a first diamine-based compound and a dicarbonyl-based compound and the fourth repeating unit is an amide repeating unit formed by polymerization of a second diamine-based compound and the dicarbonyl-based compound.

However, the polymer resin according to an embodiment of the present disclosure is not limited thereto. The polymer resin according to an embodiment of the present disclosure may be prepared from monomer components further including other compounds, in addition to the first diamine-based compound, the second diamine-based compound, the dianhydride-based compound, and the dicarbonyl-based compound. Therefore, the polymer resin according to an embodiment of the present disclosure may further include other repeating units, in addition to the imide repeating unit and the amide repeating unit.

According to an embodiment of the present disclosure, the optical film may include a polyamide-imide-based polymer. The optical film according to an embodiment of the present disclosure may include a polyamide-imide-based polymer resin. According to an embodiment of the present disclosure, the optical film may be a polyamide-imide-based film.

According to an embodiment of the present disclosure, the first diamine-based compound may be an aromatic diamine-based compound.

In an embodiment of the present disclosure, the term "aromatic diamine-based compound" refers to a diamine in which an amino group is directly bonded to an aromatic ring, and may include an aliphatic group or other substituents as part of the structure thereof. The aromatic ring may be a single ring, a fused ring including a single ring linked thereto directly via a heteroatom, or a condensed ring. Examples of the aromatic ring may include, but are not limited to, a benzene ring, a biphenyl ring, a naphthalene ring, an anthracene ring, and a fluorene ring.

According to an embodiment of the present disclosure, the first diamine-based compound may be represented by the following Formula 1:

[Formula 1] $\mathbf{H_2N\text{-}A^1\text{-}NH_2}$

wherein $A^1$ represents a divalent aromatic organic group. The aromatic organic group refers to an organic group in which pi electrons are delocalized, whereby single bonds and double bonds alternately link to each other to form rings. For example, $A^1$ may include a divalent aromatic organic group having 4 to 40 carbon atoms. A hydrogen atom in the aromatic organic group in Formula 1 may be substituted with a halogen element, a hydrocarbon group, or a hydrocarbon group substituted with a halogen element. Here, the hydrocarbon group or the hydrocarbon group substituted with the halogen element may have 1 to 8 carbon atoms. For example, the hydrogen in $A^1$ may be substituted with -F, - $CH_3$, -$CF_3$, or the like.

An optical film produced using a diamine-based compound in which a hydrogen atom is substituted with a fluorine-substituted hydrocarbon group can be imparted with excellent light transmittance and excellent workability.

$A^1$ in Formula 1 may, for example, include a structure represented by any one of the following formulas, but is not limited to any one of the following formulas.

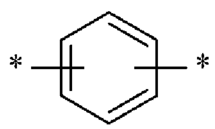
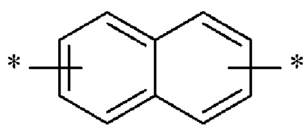

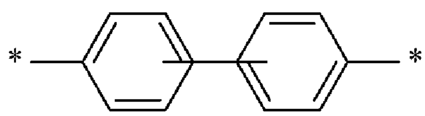
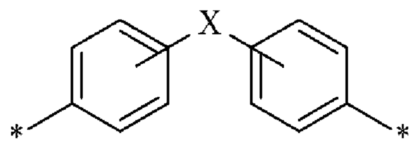

In the above formulas, * represents a bonding position. In the above formulas, X may be independently a single bond, O, S, $SO_2$, CO, $CH_2$, $C(CH_3)_2$, or $C(CF_3)_3$. Although the bonding position of X on each ring is not particularly limited, the bonding position of X may be, for example, a meta or para position on each ring.

According to an embodiment of the present disclosure, the first diamine-based compound may include at least one selected from the group consisting of 2,2'-bis(trifluoromethyl)benzidine (TFDB), 2,2-bis[4-(4-aminophenoxy)phenyl] hexafluoropropane (HFBAPP), bis[4-(4-aminophenoxy)phenyl]sulfone (BAPS), bis[4-(3-minophenoxy)phenyl]sulfone (BAPSM), 4,4'-diaminodiphenylsulfone (4DDS), 3,3'-diaminodiphenylsulfone (3DDS), para-phenylene diamine (pPDA), meta-phenylene diamine (mPDA), para-methylene dianiline (pMDA), meta-methylene dianiline (mMDA), 2,2-bis[4-(4-aminophenoxy)phenyl] propane (BAPP), 4,4'-diaminodiphenyl propane (6HDA), 1,3-bis(4-aminophenoxy)benzene (134APB), 1,3-bis(3-aminophenoxy)benzene (133APB), 1,4-bis(4-aminophenoxy)biphenyl (BAPB), 4,4'-bis(4-amino-2-trifluoromethylphenoxy)biphenyl (6FAPBP), 3,3-diamino-4,4'-dihydroxydiphenylsulfone (DABS), 2,2-bis(3-amino-4-hydroxyphenyl)propane (BAP), 4,4'-diaminodiphenylmethane (DDM), 4,4'-oxydianiline (4-ODA), 3,3'-oxydianiline (3-ODA),

2,2'-dimethyl-4,4'-(9-fluorenylidene)dianiline (MFDA), 9,9-bis(4-aminophenyl)fluorene (FDA), and 9,9-bis(3-fluoro-4-aminophenyl)fluorene (FFDA).

According to an embodiment of the present disclosure, the second diamine-based compound may be an aliphatic diamine-based compound.

In an embodiment of the present disclosure, the term "aliphatic diamine-based compound" refers to a diamine in which an amino group is directly bonded to an aromatic ring, and may include an aromatic or other substituents as part of the structure thereof. The aliphatic diamine may include a cyclic aliphatic diamine and a non-cyclic acyclic aliphatic diamine.

According to an embodiment of the present disclosure, the second diamine-based compound may be represented by the following Formula 2:

[Formula 2] $H_2N\text{-}A^2\text{-}NH_2$

wherein $A^2$ represents a divalent aliphatic organic group. For example, $A^2$ may include a divalent aliphatic organic group having 4 to 40 carbon atoms. A hydrogen atom in the aliphatic organic group in Formula 2 may be substituted with a halogen element, a hydrocarbon group, or a hydrocarbon group substituted with a halogen element. Here, the hydrocarbon group or the hydrocarbon group substituted with a halogen element may have 1 to 8 carbon atoms. For example, the hydrogen in $A^2$ may be substituted with -F, $-CH_3$, $-CF_3$, or the like.

An optical film produced using a diamine-based compound in which a hydrogen atom is substituted with a fluorine-substituted hydrocarbon group can be imparted with excellent light transmittance and excellent workability.

$A^2$ in Formula 2 may, for example, include a structure represented by any one of the following formulas, but is not limited to any one of the following formulas.

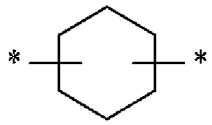 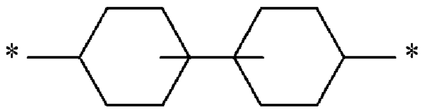 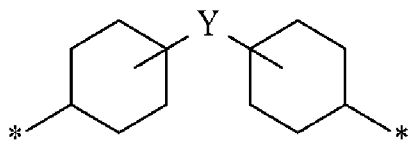

In the above formulas, * represents a bonding position. However, the amine group may be directly bonded to the bonding position, or may be bonded by an alkylene group having 1 to 3 carbon atoms. In the above formulas, Y may be independently a single bond, O, S, $SO_2$, CO, $CH_2$, $C(CH_3)_2$, or $C(CF_3)_3$. The bonding position of Y on each ring is not particularly limited.

According to an embodiment of the present disclosure, the second diamine-based compound may include at least one selected from the group consisting of 4,4'-methylenebis cyclohexylamine (MBCA), 1,3-bis(aminomethyl)cyclohexane, 1,4-cyclohexanediamine, bicyclo[2.2.1]heptanebis(methylamine), and isomers of cis, trans and mixtures of the compounds.

When the polymer resin includes a repeating unit derived from an aliphatic diamine-based compound, the yellowness and light transmittance of the film can be improved compared to when the polymer resin includes only a repeating unit derived from an aromatic diamine-based compound. As a result, an optical film having excellent optical properties can be obtained. The benzene ring included in the aromatic diamine-based compound makes the film yellow, so the yellowness of the film can be reduced using a larger amount of the aliphatic diamine-based compound than the aromatic diamine-based compound.

However, the aliphatic diamine-based compound is strongly basic and thus reacts with carboxylic acid to form a salt. Accordingly, when an aliphatic diamine-based compound is used, a general polymerization method has problems in that smooth polymerization does not occur and the degree of polymerization of the resin is lowered. If the degree of polymerization of the resin is lowered, the optical properties of the film may be deteriorated, whereby the film may be unsuitable for use as an optical film.

According to an embodiment of the present disclosure, in an attempt to improve the degree of polymerization of a polymer resin using an aliphatic diamine-based compound, for example, there is a method of minimizing the content of chlorine (Cl) in the polymer resin and the film.

In an embodiment of the present disclosure, the dianhydride-based compound may be represented by the following Formula 3:

[Formula 3]

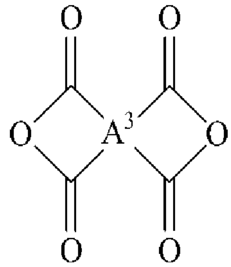

wherein $A^3$ represents a tetravalent organic group. For example, $A^3$ may include a tetravalent organic group having 4 to 40 carbon atoms. A hydrogen atom in the organic group in Formula 3 may be substituted with a halogen element, a hydrocarbon group, or a hydrocarbon group substituted with a halogen element. Here, the hydrocarbon group or the hydrocarbon group substituted with a halogen element may have 1 to 8 carbon atoms.

$A^3$ in Formula 3 may, for example, include a structure represented by any one of the following formulas.

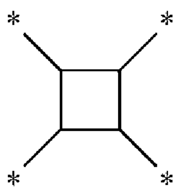
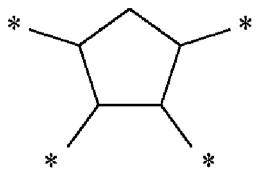
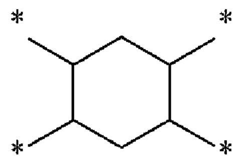
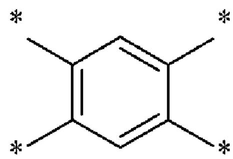

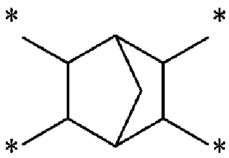
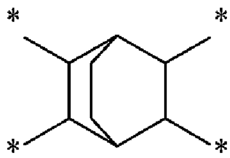
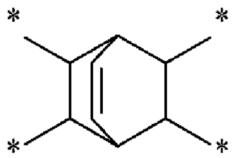
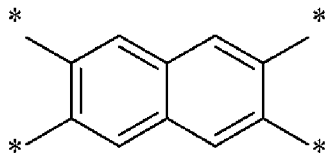

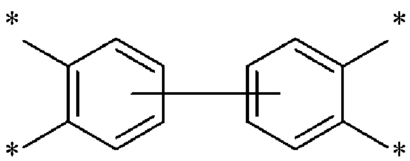
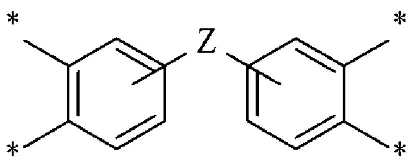

In the above formulas, * represents a bonding position. In the above formulas, Z may independently be any one of a single bond, O, S, $SO_2$, CO, $(CH_2)_n$, $(C(CH_3)_2)_n$, and $(C(CF_3)_2)_n$, and n may be an integer of 1 to 5. Although the bonding position of Z on each ring is not particularly limited, the bonding position of Z may be, for example, a meta or para position on each ring.

In an embodiment of the present disclosure, the dianhydride-based compound may include one or more selected from the group consisting of 2,2-bis(3,4-dicarboxyphenyl)hexafluoropropane dianhydride (6FDA), 4-(2,5-dioxotetrahydrofuran-3-yl)-1,2,3,4-tetrahydronaphthalene-1,2-dicarboxylic anhydride (TDA), pyromellitic dianhydride (1,2,4,5-benzene tetracarboxylic dianhydride, PMDA), 3,3,4,4-benzophenone tetracarboxylic dianhydride (BTDA), 3,3,4,4-biphenyltetracarboxylic dianhydride (BPDA), 4,4-oxydiphthalic dianhydride (ODPA), bis(3,4-dicarboxyphenyl)dimethylsilane dianhydride (SiDA), 4,4-bis(3,4-dicarboxyphenoxy)diphenyl sulfide dianhydride (BDSDA), sulfonyldiphthalic anhydride ($SO_2$DPA), cyclobutane-1,2,3,4-tetracarboxylic dianhydride (CBDA), and 4,4'-(4,4'-isopropylidenediphenoxy)bis(phthalic anhydride) (6HBDA).

The monomer used in the manufacture of the optical film according to an embodiment of the present disclosure may include, for example, a plurality of kinds of dianhydride-based compounds.

An optical film produced using a dianhydride-based compound in which a hydrogen atom is substituted with a fluorine-substituted hydrocarbon group may be imparted with excellent light transmittance and excellent workability.

According to an embodiment of the present disclosure, the dicarbonyl-based compound may be represented by the following Formula 4:

[Formula 4]

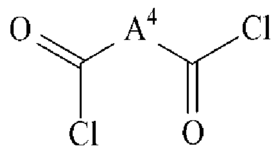

wherein $A^4$ represents a divalent group. For example, $A^4$ may include a divalent organic group having 4 to 40 carbon atoms. In addition, $A^4$ may represent a carbon atom, a nitrogen atom, or an oxygen atom. A hydrogen atom in the organic group in Formula 4 may be substituted with a halogen element, a hydrocarbon group, or a fluorine-substituted hydrocarbon group. Here, the hydrocarbon group or the fluorine-substituted hydrocarbon group may have 1 to 8 carbon atoms.

According to an embodiment of the present disclosure, the aromatic dicarbonyl-based compound may include at least one selected from the group consisting of phthaloyl chloride, terephthaloyl chloride (TPC), isophthaloyl chloride (IPC), 4,4'-biphenyldicarbonyl chloride (DPDOC), 4,4'-oxybis(benzoyl chloride) (OBBOC), and naphthalene-2,3-dicarbonyl dichloride.

The polymer resin according to an embodiment of the present disclosure may include a first repeating unit represented by the following Formula 5 and a second repeating unit represented by the following Formula 6:

[Formula 5]

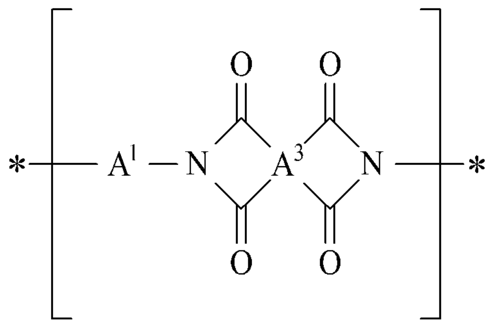

wherein $A^1$ and $A^3$ are as described above, and

[Formula 6]

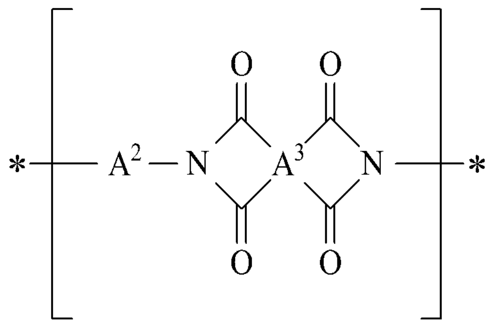

wherein $A^2$ and $A^3$ are as described above.

The polymer resin according to an embodiment of the present disclosure may include a third repeating unit represented by the following Formula 7 and a fourth repeating unit represented by the following Formula 8:

[Formula 7]

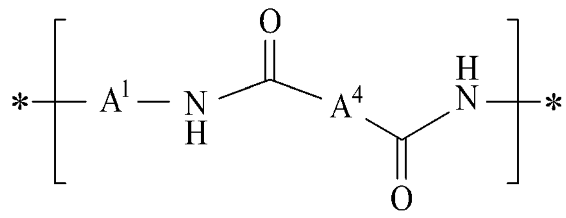

wherein $A^1$ and $A^4$ are as described above, and

[Formula 8]

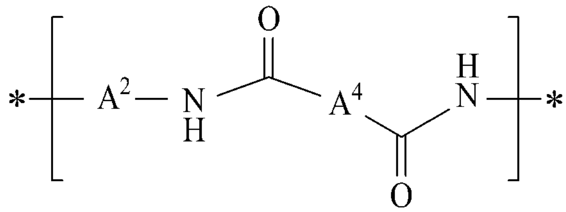

wherein $A^2$ and $A^4$ are as described above.

According to an embodiment of the present disclosure, the content of the dicarbonyl-based compound used in the manufacture of the optical film is 80 to 99 parts by mole with respect to 100 parts by mole of the total content of the dianhydride-based compound and the dicarbonyl-based compound.

In addition, the content of the dianhydride-based compound is 1 to 20 parts by mole with respect to 100 parts by mole of the total content of the dianhydride-based compound and the dicarbonyl-based compound.

In general, since the diamine compound reacts with the dianhydride-based compound or the dicarbonyl-based compound at a ratio of about 1:1 during the preparation of the polymer resin, the content of the dicarbonyl-based compound may be 80 to 99 parts by mole, and the content of the dianhydride-based compound may be 1 to 20 parts by mole, with respect to 100 parts by mole, which is the total content of the first diamine-based compound and the second diamine-based compound.

In addition, since the first and second repeating units are derived from the dianhydride-based compound and the third and fourth repeating units are derived from the dicarbonyl-based compound, the total number of third and fourth repeating units included in the polymer resin can be said to correspond to 80% to 99% of the total number of repeating units including the first to fourth repeating units, and the total number of the first and second repeating units included in the polymer resin can be said to correspond to 1 to 20% of the total number of repeating units including the first to fourth repeating units.

When the total number of repeating units including the third and fourth repeating units is 80% to 99% of the total number of repeating units including the first to fourth repeating units, the yellowness index and haze can be reduced, light transmittance can be improved, and mechanical properties can also be improved. That is, by incorporating more of the amide repeating unit than the imide repeating unit, it is possible to manufacture a film that is colorless and transparent, and has improved insolubility, chemical resistance, heat resistance, radiation resistance, low-temperature characteristics, and so on.

When a large amount of the dicarbonyl-based compound is added in order to form a large number of amide repeating units, there is a problem in that the dicarbonyl-based compound is gelled and thus the polymerization reaction is insufficiently performed.

According to an embodiment of the present disclosure, in an attempt to improve the degree of polymerization of a polymer resin using an aliphatic diamine-based compound and a great amount of dicarbonyl-based compound, for example, there is a method of minimizing the content of chlorine (Cl) in the polymer resin and the optical film.

According to an embodiment of the present disclosure, the content of chlorine (Cl) in the polymer resin is minimized. The degree of polymerization of a polymer resin having a minimized chlorine (Cl) content can be improved. An optical film including a polymer resin having minimized chlorine (Cl) content also exhibits minimized chlorine (Cl) content.

The present inventors found that when chlorine (Cl) atoms remain in the polymer resin, the degree of polymerization of the polymer resin is reduced, and the chlorine (Cl) atoms remaining in the optical film including the same

are also reduced. Specifically, when hydrochloric acid (HCl) generated during the process of manufacturing the optical film is not sufficiently removed and is present in a reaction solution for manufacturing an optical film, for example, a polymer resin precursor solution, the acidity of the reaction solution increases, reactivity is reduced, and the polymer may be degraded. In addition, in the process of manufacturing the optical film, during chemical or thermal imidization, hydrochloric acid (HCl) reacts with water ($H_2O$), causing side reactions such as generation of hydronium ions ($H_3O^+$) and chlorine ions ($Cl^-$). As a result, the optical properties of the optical film may be deteriorated. In addition, when heat and light are radiated onto an optical film containing chlorine (Cl) atoms, decomposition or degradation of the polymer included in the film is accelerated by a photo-initiation reaction by chlorine (Cl) atoms, or the chemical structure of the polymer resin may be changed. As such, when the chemical structure of the polymer resin constituting the optical film is decomposed or deteriorated and changed by heat treatment and light radiation, optical properties of the optical film may be deteriorated.

The optical film according to an embodiment of the present disclosure may contain 120 ppm by weight or less of chlorine (Cl). According to an embodiment of the present disclosure, 120 ppm may correspond to 0.012% by weight. According to an embodiment of the present disclosure, "ppm" indicates a unit in which the concentration of chlorine ions included in the optical film is measured based on weight. According to an embodiment of the present disclosure, the concentration of chlorine is measured by performing ion chromatography, and is calculated using the concentration of a standard ion chromatography solution.

According to an embodiment of the present disclosure, the concentration of chlorine in the optical film may be measured by performing ion chromatography analysis on a chlorine (Cl) extract obtained by freeze-drying and pulverizing the optical film and then extracting the film using distilled water. The powdered optical film is, for example, mixed in an amount of 5 wt% with distilled water, and chlorine (Cl) is extracted from the mixture of the powdered optical film and distilled water.

According to an embodiment of the present disclosure, the chlorine (Cl) concentration may also be referred to as a "water ($H_2O$) extraction concentration of chlorine ions".

More specifically, according to an embodiment of the present disclosure, the chlorine (Cl) extract may be obtained by cutting an optical film having a thickness of 50 um to about 0.5 cm x 0.5 cm, followed by freeze-drying and powdering and then sonication extraction for 2 hours using distilled water. By performing ion chromatography analysis on the chlorine extract and calculating the concentration of chlorine, the content of chlorine can be evaluated. For ion chromatography analysis, two columns [IonPac AS18 Analytical (4x250 mm) + AG18 Guard (4x50 mm)] and the eluent [EGC-KOH III Cartridge] can be installed on an ion chromatography system from Dionex, Dionex ICS-2000.

The optical film according to an embodiment of the present disclosure may have a low chlorine (Cl) concentration, and may thus exhibit excellent thermal and optical stability. Even if the optical film according to an embodiment of the present disclosure is heat-treated or exposed to light for a long time, the polymer structure in the optical film is not damaged or decomposed, and excellent optical and mechanical properties can be maintained.

According to an embodiment of the present disclosure, by minimizing the content of chlorine (Cl) in the optical film, it is possible to prevent deterioration of the optical and mechanical properties of the optical film.

The optical film according to an embodiment of the present disclosure, based on weight, may contain chlorine (Cl) in an amount of 120 ppm (0.012 wt%) or less, and may contain chlorine (Cl) in an amount of 50 ppm (0.005 wt%) or less. In addition, the optical film according to an embodiment of the present disclosure may contain 0.1 to 120 ppm (0.00001 to 0.012 wt%) of chlorine (Cl), or 1 to 120 ppm (0.0001 to 0.012 wt%) of chlorine (Cl).

When the optical film contains 120 ppm or less of chlorine (Cl) by weight, an optical film having a high degree of polymerization of the polymer resin can be prepared, and deterioration of optical properties of the optical film caused by chlorine (Cl) can be minimized or prevented.

According to an embodiment of the present disclosure, the term "chlorine (Cl)" is intended to include chlorine atoms and chlorine ions ($Cl^-$). In addition, according to an embodiment of the present disclosure, chlorine (Cl) may be bonded to other atoms to form molecules, and the chlorine atoms present in molecules are included in the meaning of chlorine (Cl) according to an embodiment of the present disclosure.

The optical film according to an embodiment of the present disclosure may contain chlorine (Cl) in an amount of 5 to 120 ppm (0.0005 to 0.012% by weight).

As described above, hydrochloric acid (HCl) may be generated in the process of manufacturing the optical film. When hydrochloric acid generated in the process of manufacturing the optical film is not removed, chlorine (Cl) may remain in the resulting optical film. Therefore, according to an embodiment of the present disclosure, in order to minimize the amount of chlorine (Cl) remaining in the optical film, a chlorine (Cl) acceptor for removing hydrochloric acid generated in the process of manufacturing the optical film is used.

In the process of manufacturing the optical film, the chlorine (Cl) acceptor is converted to a chlorine (Cl) compound through reaction with hydrochloric acid (HCl), and is then removed. However, a portion of the chlorine (Cl) acceptor may not react with hydrochloric acid, and may not be removed in the process of manufacturing the optical film. Therefore, the optical film according to an embodiment of the present disclosure may contain a trace amount of chlorine

(Cl) acceptor.

In one embodiment of the present disclosure, the chlorine (Cl) acceptor is a substance capable of reacting with hydrochloric acid (HCl) or chlorine ions (Cl-). The chlorine (Cl) acceptor may be selected from substances that can be removed in a subsequent process after reaction with hydrochloric acid (HCl) or chlorine ions ($Cl^-$) in the process of manufacturing the optical film.

The chlorine (Cl) acceptor may, for example, react with hydrochloric acid to form a salt or a halohydrin compound, thereby serving to remove hydrochloric acid generated during polymerization.

In an embodiment of the present disclosure, a cyclic ether-based compound may be used as the chlorine (Cl) acceptor. The cyclic ether-based compound may, for example, include at least one of an epoxide-based compound, an oxetane-based compound, a tetrahydrofuran-based compound, and a tetrahydropyran-based compound.

The optical film according to an embodiment of the present disclosure may contain 0.1 to 30 ppm by weight of the cyclic ether-based compound. More specifically, the optical film according to an embodiment of the present disclosure may contain 0.1 to 12 ppm by weight of a cyclic ether-based compound.

According to an embodiment of the present disclosure, an epoxide-based compound represented by the following Formula 9 may be used as the chlorine (Cl) acceptor:

[Formula 9]

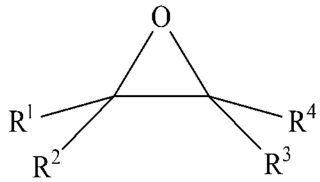

wherein $R^1$, $R^2$, $R^3$, and $R^4$ are each independently hydrogen or an organic group having 1 to 20 carbon atoms. More specifically, $R^1$, $R^2$, $R^3$, and $R^4$ may each independently be hydrogen or a substituted or unsubstituted hydrocarbon group having 1 to 20 carbon atoms. According to an embodiment of the present disclosure, $R^1$, $R^2$, $R^3$, and $R^4$ may each independently be hydrogen or an alkyl group having 1 to 10 carbon atoms.

According to an embodiment of the present disclosure, among the epoxide-based compounds represented by Formula 9, propylene oxide (PO) may be used as the chlorine (Cl) acceptor.

The epoxide-based compound used as the chlorine (Cl) acceptor may react with hydrochloric acid (HCl) or chlorine (Cl) in accordance with the following Reaction Scheme 1:

[Reaction Scheme 1]

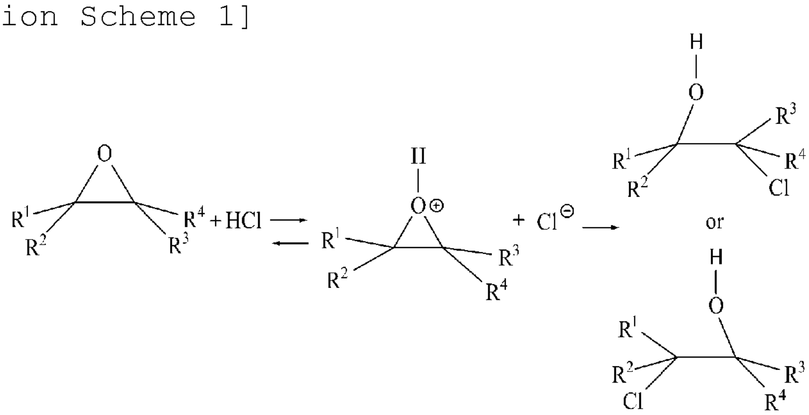

wherein $R^1$, $R^2$, $R^3$ and $R^4$ are as described above. In Reaction Scheme 1, only structural isomers determined depending on the difference in the position of carbon to which chlorine (Cl) is bonded are shown, but diastereomers or enantiomers determined based on stereocenters (chiral centers) may also be formed.

In one embodiment of the present disclosure, the reaction product of the chlorine (Cl) acceptor and hydrochloric acid (HCl) is removed in the process of manufacturing the optical film. As a result, chlorine (Cl) can be removed. However, the reaction product of the chlorine (Cl) acceptor and chlorine (Cl) may remain in the optical film without being removed. Accordingly, the optical film according to an embodiment of the present disclosure may contain a trace amount of the reaction product of the chlorine (Cl) acceptor and hydrochloric acid (HCl) or chlorine (Cl).

When propylene oxide (PO) is used as the chlorine (Cl) acceptor, the chlorine acceptor may react with hydrochloric acid (HCl) in accordance with the following Reaction Scheme 2:

[Reaction Scheme 2]

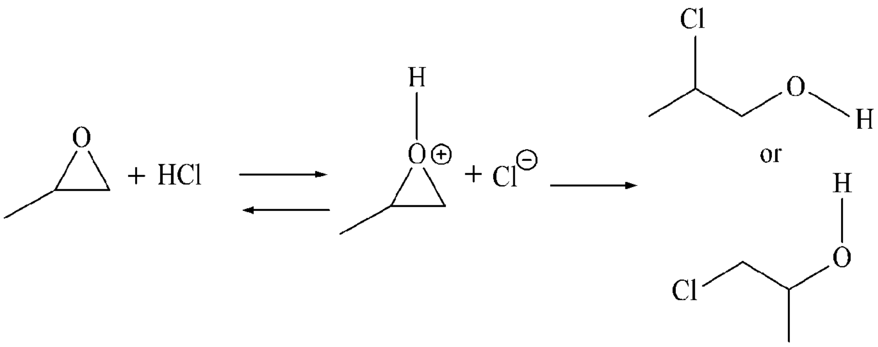

According to an embodiment of the present disclosure, the total number of first repeating units and third repeating units may be present at a ratio of 85% to 95% with respect to the total number of repeating units including the first to fourth repeating units. That is, the content of the first diamine-based compound used for manufacturing the optical film may be 85 to 95 parts by mole based on 100 parts by mole of the total content of the first diamine-based compound and the second diamine-based compound, and the content of the second diamine-based compound may be 5 to 15 parts by mole based on 100 parts by mole of the total content of the first diamine-based compound and the second diamine-based compound.

When the content of the second diamine-based compound is less than 5 parts by mole, which is an aliphatic diamine-based compound, there may be a problem in that the optical properties of the optical film are deteriorated. On the other hand, if the content exceeds 15 parts by mole, there may be a problem of deterioration in the mechanical properties of the optical film.

According to an embodiment of the present disclosure, the number average molecular weight ($M_n$) of the polymer resin may be 150,000 or more.

The aliphatic diamine-based compound and the dicarbonyl-based compound have low reactivity due to side reactions or gelation, and thus the degree of polymerization of the polymer resin including the aliphatic diamine-based compound and the dicarbonyl-based compound is deteriorated. The number average molecular weight is proportional to the degree of polymerization, and as the degree of polymerization decreases, the number average molecular weight of the polymer resin also decreases.

When the number average molecular weight of the polymer resin is less than 150,000, the degree of polymerization is reduced, the number of end groups of the polymer chain is increased, and the physical properties of the resin are deteriorated.

According to an embodiment of the present disclosure, the optical film is light-transmissive and flexible. For example, the optical film according to an embodiment of the present disclosure is bendable, foldable, or rollable.

The optical film according to an embodiment of the present disclosure may have a yellowness index of 4.0 or less. In addition, the optical film according to an embodiment of the present disclosure may have a yellowness index of 3.0 or less or a yellowness index of 2.0 or less.

The optical film according to an embodiment of the present disclosure may have light transmittance of 88.50% or more. In addition, the optical film according to an embodiment of the present disclosure may have light transmittance of 90% or more or light transmittance of 91% or more, based on a thickness of 50 um.

The yellowness index and light transmittance may be measured in a wavelength range of 360 to 740 nm using a spectrophotometer according to the ASTM E313 standard. The spectrophotometer used herein may be, for example, CM-3700D manufactured by KONICA MINOLTA.

The optical film according to an embodiment of the present disclosure may be applied to a display device to protect the display surface of the display panel. The optical film according to an embodiment of the present disclosure may have a thickness sufficient to protect the display panel. For example, the optical film may have a thickness of 10 to 100 um.

Hereinafter, a display device including the optical film according to an embodiment of the present disclosure will be described with reference to FIGS. 1 and 2.

FIG. 1 is a cross-sectional view illustrating a part of a display device 200 according to another embodiment, and FIG. 2 is an enlarged cross-sectional view of "P" in FIG. 1.

Referring to FIG. 1, the display device 200 according to another embodiment of the present disclosure includes

a display panel 501 and an optical film 100 on the display panel 501.

Referring to FIGS. 1 and 2, the display panel 501 includes a substrate 510, a thin film transistor TFT on the substrate 510, and an organic light-emitting device 570 connected to the thin film transistor TFT. The organic light-emitting device 570 includes a first electrode 571, an organic light-emitting layer 572 on the first electrode 571, and a second electrode 573 on the organic light-emitting layer 572. The display device 200 shown in FIGS. 1 and 2 is an organic light-emitting display device.

The substrate 510 may be formed of glass or plastic. Specifically, the substrate 510 may be formed of plastic such as a polymer resin or an optical film. Although not shown, a buffer layer may be disposed on the substrate 510.

The thin film transistor TFT is disposed on the substrate 510. The thin film transistor TFT includes a semiconductor layer 520, a gate electrode 530 that is insulated from the semiconductor layer 520 and at least partially overlaps the semiconductor layer 520, a source electrode 541 connected to the semiconductor layer 520, and a drain electrode 542 that is spaced apart from the source electrode 541 and is connected to the semiconductor layer 520.

Referring to FIG. 2, a gate insulating layer 535 is disposed between the gate electrode 530 and the semiconductor layer 520. An interlayer insulating layer 551 may be disposed on the gate electrode 530, and a source electrode 541 and a drain electrode 542 may be disposed on the interlayer insulating layer 551.

A planarization layer 552 is disposed on the thin film transistor TFT to planarize the top of the thin film transistor TFT.

A first electrode 571 is disposed on the planarization layer 552. The first electrode 571 is connected to the thin film transistor TFT through a contact hole provided in the planarization layer 552.

A bank layer 580 is disposed on the planarization layer 552 in a part of the first electrode 571 to define pixel areas or light-emitting areas. For example, the bank layer 580 is disposed in the form of a matrix at the boundaries between a plurality of pixels to define the respective pixel regions.

The organic light-emitting layer 572 is disposed on the first electrode 571. The organic light-emitting layer 572 may also be disposed on the bank layer 580. The organic light-emitting layer 572 may include one light-emitting layer, or two light-emitting layers stacked in a vertical direction. Light having any one color among red, green, and blue may be emitted from the organic light-emitting layer 572, and white light may be emitted therefrom.

The second electrode 573 is disposed on the organic light-emitting layer 572.

The first electrode 571, the organic light-emitting layer 572, and the second electrode 573 may be stacked to constitute the organic light-emitting device 570.

Although not shown, when the organic light-emitting layer 572 emits white light, each pixel may include a color filter for filtering the white light emitted from the organic light-emitting layer 572 based on a particular wavelength. The color filter is formed in the light path.

A thin-film encapsulation layer 590 may be disposed on the second electrode 573. The thin-film encapsulation layer 590 may include at least one organic layer and at least one inorganic layer, and the at least one organic layer and the at least one inorganic layer may be alternately disposed.

The optical film 100 is disposed on the display panel 501 having the stack structure described above.

Hereinafter, a method of manufacturing an optical film according to another embodiment of the present disclosure will be described.

The method of manufacturing an optical film according to an embodiment of the present disclosure includes forming a first reaction solution using at least one of a first diamine-based compound and a second diamine-based compound, a dianhydride-based compound, a dicarbonyl-based compound and a chlorine (Cl) acceptor, adding a dehydrating agent and an imidization catalyst to the first reaction solution and allowing a reaction to occur therebetween to form a second reaction solution, treating the second reaction solution to prepare a polymer resin in a solid phase, dissolving the solid-phase polymer resin to prepare a polymer resin solution, and casting the polymer resin solution. Hereinafter, each step will be described in detail.

First, the first reaction solution is formed using at least one of the first diamine-based compound and the second diamine-based compound, the dianhydride-based compound, the dicarbonyl-based compound, and the chlorine (Cl) acceptor.

The solvent for preparing the first reaction solution may be, for example, a polar aprotic organic solvent such as N,N-dimethylacetamide (DMAc), N,N-dimethylformamide (DMF), 1-methyl-2-pyrrolidinone (NMP), m-cresol, tetrahydrofuran (THF), chloroform, methyl ethyl ketone (MEK), or a mixture thereof. However, the solvent according to an embodiment of the present disclosure is not limited thereto, and other solvents may be used.

According to an embodiment of the present disclosure, the first diamine-based compound may be an aromatic diamine-based compound. As the first diamine-based compound, the compounds of Formula 1 described above may be used.

According to an embodiment of the present disclosure, the second diamine-based compound may be an aliphatic diamine-based compound. As the second diamine-based compound, the compounds of Formula 2 described above may be used.

According to an embodiment of the present disclosure, the compounds of Formula 3 described above may be used as the dianhydride-based compound.

According to an embodiment of the present disclosure, the compounds of Formula 4 described above may be used as the dicarbonyl-based compound.

For example, the first diamine-based compound may include at least one selected from the group consisting of 2,2'-bis(trifluoromethyl)benzidine (TFDB), 2,2-bis[4-(4-aminophenoxy)phenyl]hexafluoropropane (HFBAPP), bis[4-(4-aminophenoxy)phenyl]sulfone (BAPS), bis[4-(3-minophenoxy)phenyl]sulfone (BAPSM), 4,4'-diaminodiphenylsulfone (4DDS), 3,3'-diaminodiphenylsulfone (3DDS), para-phenylene diamine (pPDA), meta-phenylene diamine (mPDA), para-methylene dianiline (pMDA), meta-methylene dianiline (mMDA), 2,2-bis[4-(4-aminophenoxy)phenyl] propane (BAPP), 4,4'-diaminodiphenyl propane (6HDA), 1,3-bis(4-aminophenoxy)benzene (134APB), 1,3-bis(3-aminophenoxy)benzene (133APB), 1,4-bis(4-aminophenoxy)biphenyl (BAPB), 4,4'-bis(4-amino-2-trifluoromethylphenoxy)biphenyl (6FAPBP), 3,3-diamino-4,4'-dihydroxydiphenylsulfone (DABS), 2,2-bis(3-amino-4-hydroxyphenyl)propane (BAP), 4,4'-diaminodiphenylmethane (DDM), 4,4'-oxydianiline (4-ODA), 3,3'-oxydianiline (3-ODA), 2,2'-dimethyl-4,4'-(9-fluorenylidene)dianiline (MFDA), 9,9-bis(4-aminophenyl)fluorene (FDA) and 9,9-bis(3-fluoro-4-aminophenyl)fluorene (FFDA).

For example, the second diamine-based compound may include at least one selected from the group consisting of 4,4'-methylenebis cyclohexylamine (MBCA), 1,3-bis(aminomethyl)cyclohexane, 1,4-cyclohexanediamine, bicyclo [2.2.1]heptanebis(methylamine), and isomers of cis, trans and mixtures of the compounds.

For example, the dianhydride-based compound may include at least one selected from the group consisting of 2,2-bis(3,4-dicarboxyphenyl)hexafluoropropane dianhydride (6FDA), 4-(2,5-dioxotetrahydrofuran-3-yl)-1,2,3,4-tetrahydronaphthalene-1,2-dicarboxylic anhydride (TDA), 1,2,4,5-benzene tetracarboxylic dianhydride (pyromellitic dianhydride, PMDA), 3,3,4,4-benzophenone tetracarboxylic dianhydride (BTDA), 3,3,4,4-biphenyltetracarboxylic dianhydride (BPDA), 4,4-oxydiphthalic dianhydride (ODPA), bis(3,4-dicarboxyphenyl)dimethylsilane dianhydride (SiDA), 4,4-bis(3,4-dicarboxyphenoxy)diphenyl sulfide dianhydride (BDSDA), sulfonyldiphthalic anhydride ($SO_2$DPA), cyclobutane-1,2,3,4-tetracarboxylic dianhydride (CBDA), and 4,4'-(4,4'-isopropylidenediphenoxy)bis(phthalic anhydride) (6HBDA).

For example, the dicarbonyl-based compound may be phthaloyl chloride, terephthaloyl chloride (TPC), isophthaloyl chloride (IPC), 4,4'-biphenyldicarbonyl chloride (DPDOC), 4,4'-oxybis(benzoyl chloride) (OBBOC), naphthalene-2,3-dicarbonyl dichloride, or the like.

The first diamine-based compound, the second diamine-based compound, the dianhydride-based compound, and the dicarbonyl-based compound may be used alone or in combination of two or more thereof.

According to an embodiment of the present disclosure, the dicarbonyl-based compound may be used in an amount of 80 to 99 parts by mole, and the dianhydride-based compound may be used in an amount of 1 to 20 parts by mole, based on 100 parts by mole, which is the total content of the first diamine-based compound and the second diamine-based compound.

The effects obtained depending on the amount of the dicarbonyl-based compound that is added are the same as described above.

According to an embodiment of the present disclosure, the first diamine-based compound may be used in an amount of 85 to 95 parts by mole based on 100 parts by mole of the total content of the first diamine-based compound and the second diamine-based compound, and the second diamine-based compound may be used in an amount of 5 to 15 parts by mole based on 100 parts by mole of the total content of the first diamine-based compound and the second diamine-based compound.

The effects obtained depending on the amount of the first diamine-based compound that is added are the same as described above.

A chlorine (Cl) compound may be produced during the reaction between the first diamine-based compound and the second diamine-based compound and the dicarbonyl-based compound. In order to remove the chlorine compound, according to an embodiment of the present disclosure, a chlorine (Cl) acceptor is used in the first reaction solution formation process.

According to an embodiment of the present disclosure, the chlorine (Cl) acceptor may be a cyclic ether-based compound. For example, the cyclic ether-based compound may include at least one of an epoxide-based compound, an oxetane-based compound, a tetrahydrofuran-based compound, and a tetrahydropyran-based compound.

According to an embodiment of the present disclosure, an epoxide-based compound represented by the following Formula 9 may be used as the chlorine (Cl) acceptor:

[Formula 9]

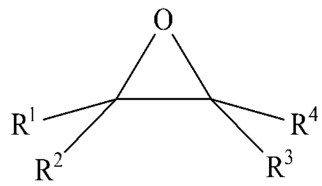

wherein $R^1$, $R^2$, $R^3$, and $R^4$ are each independently hydrogen or an organic group having 1 to 20 carbon atoms. More specifically, $R^1$, $R^2$, $R^3$, and $R^4$ may each independently be hydrogen or a substituted or unsubstituted hydrocarbon group having 1 to 20 carbon atoms. According to an embodiment of the present disclosure, $R^1$, $R^2$, $R^3$, and $R^4$ may each independently be hydrogen or an alkyl group having 1 to 10 carbon atoms.

The epoxide-based compound used as the chlorine (Cl) acceptor may react with hydrochloric acid (HCl) in accordance with the following Reaction Scheme 1. As a result, hydrochloric acid (HCl) may be removed from the first reaction solution.

[Reaction Scheme 1]

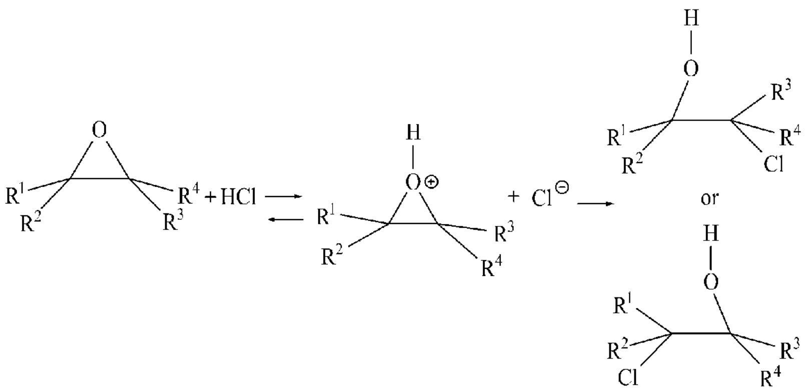

Here, $R^1$, $R^2$, $R^3$ and $R^4$ are as described above. In Reaction Scheme 1, only structural isomers determined depending on the difference in the position of carbon to which chlorine (Cl) is bonded are shown, but diastereomers or enantiomers based on stereocenters (chiral centers) may also be formed.

According to an embodiment of the present disclosure, propylene oxide (PO) among the epoxide-based compounds may be used as a chlorine (Cl) acceptor.

When propylene oxide (PO) is used as the chlorine (Cl) acceptor, hydrochloric acid (HCl) may be removed in accordance with the following Reaction Scheme 2:

[Reaction Scheme 2]

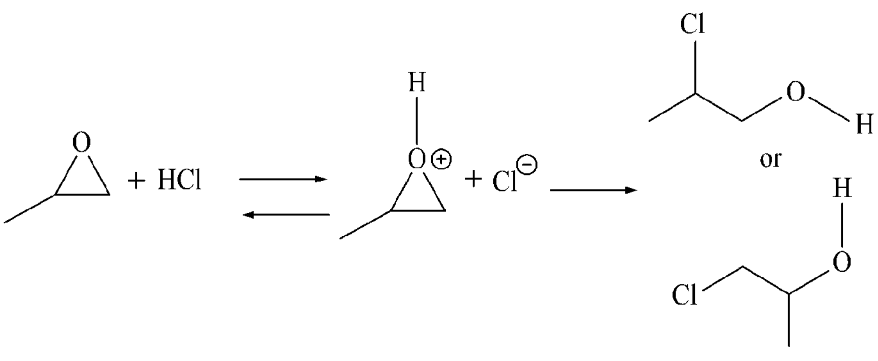

According to an embodiment of the present disclosure, the content of the chlorine (Cl) acceptor, based on the

number of moles, may be 4 to 7 times the content of the dicarbonyl-based compound. Considering the reaction scheme of the diamine-based compound, particularly the aliphatic diamine-based compound and the dicarbonyl-based compound, theoretically, when the content of the chlorine (Cl) acceptor with respect to the dicarbonyl-based compound is doubled, the hydrochloric acid (HCl) produced by the reaction of the diamine-based compound and the dicarbonyl-based compound can be removed by a chlorine acceptor. However, as confirmed by the present inventors, when the molar content of the chlorine (Cl) acceptor was less than 4 times that of the dicarbonyl-based compound, the reaction between the chlorine (Cl) acceptor and hydrochloric acid (HCl) did not sufficiently progress, so chlorine (Cl) removal efficiency was reduced. In addition, when a chlorine (Cl) acceptor was used in an amount corresponding to 7 times the number of moles of the dicarbonyl-based compound, the degree of polymerization was lowered due to the excess chlorine (Cl) acceptor. Therefore, according to an embodiment of the present disclosure, the content of the chlorine (Cl) acceptor was adjusted to 4 to 7 times the content of the dicarbonyl-based compound, based on the number of moles.

According to one embodiment of the present disclosure, the first reaction solution contains polyamic acid and a polyamide repeating unit. Polyamic acid is a precursor of polyimide.

Next, a dehydrating agent and an imidization catalyst are added to the first reaction solution and allowed to react therewith to form a second reaction solution.

During the formation of the second reaction solution, a portion of the amic acid may be imidized to form an imide repeating unit.

According to an embodiment of the present disclosure, the dehydrating agent and the imidization catalyst are added to the first reaction solution, followed by refluxing at a temperature of 60 to 80°C for 30 minutes to 2 hours. As a result, a second reaction solution may be formed.

As the dehydrating agent, an acid anhydride such as acetic anhydride, propionic anhydride, isobutyric anhydride, pivalic anhydride, butyric anhydride, or isovaleric anhydride may be used.

As the imidation catalyst, a tertiary amine such as isoquinoline, beta-picoline, or pyridine may be used.

The pH of the second reaction solution may be adjusted by the chlorine (Cl) acceptor and the imidization catalyst. According to an embodiment of the present disclosure, the second reaction solution may have a pH of 8 or more.

According to an embodiment of the present disclosure, the content of the chlorine (Cl) acceptor that is added when the first reaction solution is formed may be adjusted such that the pH of the second reaction solution is 8 to 9. According to an embodiment of the present disclosure, the second reaction solution has a pH of 8 to 9.

When the second reaction solution is in a weakly basic state of pH 8 to 9, it may be meant that all or most of the hydrochloric acid (HCl) generated during the formation of the first reaction solution has reacted with the chlorine (Cl) acceptor.

When the pH of the second reaction solution is less than 8, the hydrochloric acid (HCl) that is generated when the first reaction solution is formed is not sufficiently removed, and chlorine (Cl) and chlorine compounds derived from residual hydrochloric acid (HCl) are highly likely to be present in the optical film.

Considering the pH of the second reaction solution, the imidization catalyst may be used in a molar amount 2 to 7 times that of the dianhydride-based compound.

Next, the second reaction solution is treated to prepare a polymer resin in a solid phase.

In order to prepare the solid-phase polymer resin, a solvent may be added to the second reaction solution. The solvent may, for example, be ethanol, methanol, hexane, or the like. The solvent may be used alone or in a mixture of two or more solvents.

When a solvent that has low polarity and is miscible with the polymerization solvent is added to the second reaction solution, a solid polymer resin in a powder phase is precipitated. By filtering and drying the precipitate, a highly pure solid polymer resin can be obtained. When liquid components are removed in the process of filtering the precipitate, unreacted monomers, oligomers, additives, and reaction byproducts are removed. The solid polymer resin thus obtained does not contain chlorine (Cl), or contains only a trace amount of chlorine (Cl). The polymer resin may be a polyamide-imide resin including an imide repeating unit and an amide repeating unit.

Next, the solid-phase polymer resin is dissolved to prepare a polymer resin solution. By dissolving the solid-phase polymer resin in a solvent, a polymer resin solution can be prepared. This step is called "re-dissolution".

The solvent used to dissolve the solid-phase polymer resin may be the same as any of those used in the polymerization. The solvent that can be used to dissolve the solid-phase polymer resin may, for example, be a polar aprotic organic solvent such as N,N-dimethylacetamide (DMAc), N,N-dimethylformamide (DMF), 1-methyl-2-pyrrolidinone (NMP), m-cresol, tetrahydrofuran (THF), chloroform, methyl ethyl ketone (MEK), or a mixture thereof. However, the solvent according to the present disclosure is not limited thereto, and other well-known solvents may also be used.

According to an embodiment of the present disclosure, the re-dissolved polymer resin solution may have a pH of 6 to 7. According to an embodiment of the present disclosure, the polyamide-imide resin solution may have a weak acidity or weak acidity close to neutrality. The third reaction solution is prepared at a weakly basic pH of 8 to 9, so the polymer resin solution can be imparted with a weakly acidic pH of 6 to 7.

Next, the polymer resin solution is cast.

A casting substrate is used for casting. There is no particular limitation as to the type of casting substrate. The casting substrate may be a glass substrate, a stainless steel (SUS) substrate, a Teflon substrate, or the like. According to an embodiment of the present disclosure, the casting substrate may be, for example, a glass substrate.

Specifically, casting is achieved by applying the polymer resin solution to the casting substrate. A coater, a blade, or the like may be used for casting.

After casting, the polymer resin solution is dried while the temperature is elevated to 80 to 120°C at a rate of 2°C/min to produce a coating film of the polymer resin. The coating film produced in this way can be said to be an intermediate of the optical film. After the coating film is pulled taut on a pin-type tenter and fixed thereto, heat treatment is performed while the temperature is elevated from 120°C to a maximum temperature of 250°C to 350°C at a temperature elevation rate of 3°C/min. When the temperature reaches the maximum coating film formation temperature, additional heat treatment may be performed in a constant-temperature atmosphere for 10 to 30 minutes. As a result, an optical film can be manufactured.

Hereinafter, the present disclosure will be described in more detail with reference to exemplary examples and comparative examples. However, the following examples and comparative examples should not be construed as limiting the scope of the present disclosure.

<Example 1>

451.63 g of N,N-dimethylacetamide (DMAc) was charged in a 500 mL reactor equipped with a stirrer, a nitrogen injector, a dropping funnel, a temperature controller, and a cooler while nitrogen was passed through the reactor. Then, the temperature of the reactor was adjusted to 25°C, 45.37g (0.85 mol%) of TFDB as a first diamine-based compound was dissolved therein, and the temperature was maintained at 25°C. 5.26 g (0.015 mol%) of MBCA as a second diamine-based compound was further added thereto and dissolved and reacted for 1 hour. After dissolution of the first and second diamine-based compounds, 14.81g (0.20 mol%) of 6FDA was added to the resulting diamine solution, followed by reaction for 1 hour. The reactor temperature was lowered to 5°C, 27.07g (0.80 mol%) of TPC and 34.85g of propylene oxide were added thereto and completely dissolved and allowed to react with stirring for 1 hour to form a first reaction solution.

After completion of polymerization, 5.80 g of pyridine and 7.49 g of acetic anhydride were added to the first reaction solution, stirred for 30 minutes, stirred again for 30 minutes at 80°C, and allowed to cool to room temperature to obtain a second reaction solution.

Methanol was added to the second reaction solution thus obtained to cause precipitation, and the precipitate was filtered to prepare a polymer resin as a white solid. The obtained polymer resin was in a solid powder state.

The obtained polymer resin in a solid powder state was dissolved in DMAc at a concentration of 12.7 wt% to prepare a polymer resin solution.

The obtained second reaction solution was cast. A casting substrate was used for casting. There is no particular limitation as to the type of the casting substrate. As the casting substrate, a glass substrate, a stainless steel (SUS) substrate, a Teflon substrate, or the like may be used. According to an embodiment of the present disclosure, an organic substrate may be used as the casting substrate.

Specifically, the obtained polymer resin solution was applied onto a glass substrate using a Mayer bar coater, cast, and heat-treated from 80°C to 120°C for 17 minutes to produce an optical film.

Then, the produced film was peeled off of the glass substrate and fixed to a frame with pins.

The frame to which the optical film was fixed was slowly heated in a hot air oven from 120°C to 250°C for 2 hours. The dried film was dried again at 230°C for 5 minutes. As a result, an optical film having a thickness of 50 um was completed.

<Examples 2 to 9>

The polymer resins, polymer resin solutions, and optical films of Examples 2 to 9 were prepared in the same manner as in Example 1, except that the type and/or content of the first diamine-based compound, the type and/or content of the second diamine-based compound, the content of the dianhydride-based compound, the type and/or content of the dicarbonyl-based compound, and the content of each of DMAc, propylene oxide, pyridine, and acetic anhydride were changed.

Details on the type and/or content of the first diamine-based compound, the type and/or content of the second diamine-based compound, the content of the dianhydride-based compound, the type and/or content of the dicarbonyl-based compound, and the content of each of DMAc, propylene oxide, pyridine and acetic anhydride in Examples 2 to 9 are shown in Table 1 below.

<Comparative Example 1 to 6>

The polymer resins, polymer resin solutions, and optical films of Comparative Examples 1 to 6 were prepared in the same manner as in Example 1, except that the type and/or content of the first diamine-based compound, the type and/or content of the second diamine-based compound, the content of the dianhydride-based compound, the type and/or content of the dicarbonyl-based compound, and the content of each of DMAc, propylene oxide, pyridine and acetic anhydride were changed.

Details on the type and/or content of the first diamine-based compound, the type and/or content of the second diamine-based compound, the content of the dianhydride-based compound, the type and/or content of the dicarbonyl-based compound, and the content of each of DMAc, propylene oxide, pyridine and acetic anhydride in Comparative Examples 1 to 6 are shown in Table 1 below.

[Table 1]

| Type | First diamine-based compound | Second diamine-based compound | Dianhydride-based compound | Dicarbonyl-based compound | DMAc (g) | Propylene oxide (g) | Pyridine (g) | Acetic anhydride |
|---|---|---|---|---|---|---|---|---|
| Example 1 | TFDB 85 mol% (45.37g) | MBCA 15mol% (5.26g) | 6FDA 20 mol% (14.81g) | TPC 80 mol% (27.07g) | 451.63 | 34.85 | 5.80 | 7.49 |
| Example 2 | TFDB 95 mol% (50.70g) | MBCA 5 mol% (1.75g) | 6FDA 20 mol% (14.81g) | TPC 80 mol% (27.07g) | 460.57 | 34.85 | 5.80 | 7.49 |
| Example 3 | TFDB 90 mol% (48.03g) | MBCA 10 mol% (3.51g) | 6FDA 10 mol% (7.40g) | TPC 90 mol% (30.45g) | 436.47 | 39.20 | 2.90 | 3.74 |
| Example 4 | TFDB 85 mol% (45.37g) | MBCA 15 mol% (5.26g) | 6FDA 1 mol% (0.74g) | TPC 99 mol% (33.50g) | 414.33 | 43.12 | 0.29 | 0.37 |
| Example 5 | TFDB 95 mol% (50.70g) | MBCA 5 mol% (1.75g) | 6FDA 1 mol% (0.74g) | TPC 99 mol% (33.50g) | 423.27 | 43.12 | 0.29 | 0.37 |
| Example 6 | TFDB 85 mol% (45.37g) | MBCA 15 mol% (5.26g) | 6FDA 20 mol% (14.81g) | IPC 80 mol% (27.07g) | 451.63 | 34.85 | 5.80 | 7.49 |
| Example 7 | 3DDS 85 mol% (35.18g) | MBCA 15 mol% (5.26g) | 6FDA 20 mol% (14.81g) | TPC 80 mol% (27.07g) | 401.88 | 34.85 | 5.80 | 7.49 |
| Example 8 | TFDB 95 mol% (50.70g) | tCHD 5 mol% (0.95g) | 6FDA 20 mol% (14.81g) | TPC 80 mol% (27.07g) | 456.66 | 34.85 | 5.80 | 7.49 |
| Example 9 | 3DDS 95 mol% (39.31g) | tCHD 5 mol% (0.95g) | 6FDA 20 mol% (14.81g) | TPC 80 mol% (27.07g) | 401.05 | 34.85 | 5.80 | 7.49 |
| Comparative Example 1 | TFDB 85 mol% (45.37g) | MBCA 15 mol% (5.26g) | 6FDA 20 mol% (14.81g) | TPC 80 mol% (27.07g) | 451.63 | - | 5.80 | 7.49 |
| Comparative Example 2 | TFDB 85 mol% (45.37g) | MBCA 15 mol% (5.26g) | 6FDA 25 mol% (18.51g) | TPC 75 mol% (25.38g) | 461.45 | 32.67 | 7.25 | 9.36 |

(continued)

| Type | First diamine-based compound | Second diamine-based compound | Dianhydride-based compound | Dicarbonyl-based compound | DMAc (g) | Propylene oxide (g) | Pyridine (g) | Acetic anhydride |
|---|---|---|---|---|---|---|---|---|
| Comparative Example 3 | TFDB 85 mol% (45.37g) | MBCA 15 mol% (5.26g) | 6FDA 20 mol% (14.81g) | TPC 80 mol% (27.07g) | 451.63 | 27.2 | 5.8 | 7.49 |
| Comparative Example 4 | TFDB 85 mol% (45.37g) | MBCA 15 mol% (5.26g) | 6FDA 20 mol% (14.81g) | TPC 80 mol% (27.07g) | 451.63 | 58.2 | 5.8 | 7.49 |
| Comparative Example 5 | TFDB 85 mol% (45.37g) | MBCA 15 mol% (5.26g) | - | TPC 100 mol% (33.84g) | 451.63 | 34.85 | 5.8 | 7.49 |
| Comparative Example 6 | TFDB 85 mol% (45.37g) | MBCA 15 mol% (5.26g) | 6FDA 20 mol% (14.81g) | TPC 80 mol% (27.07g) | 451.63 | 17.42 | 2.9 | 3.74 |

<Measurement Example>

The following measurements were performed on the polymer resins and optical films produced in Examples and Comparative Example.

1) pH of second reaction solution and polymer resin solution:

The prepared solution (second reaction solution or polymer resin solution) is diluted with DMAc at the same concentration (wt%). In order to obtain a relative comparison between the pH of the organic solutions, the concentrations (wt%) should be the same. In the present disclosure, all solutions for measuring pH were prepared and measured based on 12 wt%.

Measurement device: an InLab® Power Pro-ISM sensor was installed in a pH meter from Mettler Toledo (model name: Seven compact S220) and used for analysis.

Measurement method: the pH of the solution was measured, a standard solution (assay reagent) having a pH of 7 was measured, and the equipment was allowed to stabilize. Whether or not the pH of the standard solution was 7.0±0.2 was observed at least three times. After equipment stabilization was performed, sample measurement commenced.

The solutions (second reaction solution or polymer resin solution) prepared in Examples and Comparative Examples were diluted to 12 wt% using DMAc. 15 ml of the prepared solution was divided into vials to prepare a sample for measurement. The sample for measurement was stored at room temperature (25±2°C), and the pH sensor was immersed in the sample for measurement at the corresponding measurement temperature. Each sample was measured at least five times and the mode was taken as the pH of the solution.

The sensor surface was washed with distilled water between sample measurements, wiped with a soft wipe, and dried sufficiently before use.

2) Number average molecular weight of polymer resin:

The number average molecular weight and molecular weight distribution were determined using GPC (standard polystyrene, solvent THF).

The details of the analysis equipment, analysis conditions, and sample preparation methods are as follows.

1. Analysis Equipment GPC Waters Set

- Module: Waters Alliance e2695
- Detector: Waters 2414 Refractive index Detector

2. Assay conditions:

- Columns: Agilent PLgel 5um Mixed C*2 (w/1 guard column)
- Mobile Phase: 10mM LiBr in DMAc
- Column and Detector Temperature: 50°C
- Injection Volume: 20 μl
- Flow Rate: 1.0 ml/min

3. Sample Preparation

- (Solid Contents) 0.25 (w/w)% in DMAc
- Fully Dissolved Samples were filtered with 0.45um pore sized PTFE syringe filter

3) Chlorine (Cl) content (ppm):

For the optical films produced in Examples and Comparative Examples, chlorine (Cl) content was measured as follows.

Measurement apparatus: Ion chromatography analysis was performed using two columns [IonPac AS18 Analytical (4 x 250 mm) + AG18 Guard (4×50 mm)] and an eluent [EGC-KOH III Cartridge from Dionex] in an ICS-2000 ion chromatography system from Dionex.

Measurement method: each of the 50-um-thick optical films manufactured in Examples and Comparative Examples was cut to a size of about 0.5 cm x 0.5 cm followed by freeze-drying and pulverizing to prepare an optical film powder. Then, the optical film powder was mixed with distilled water at a concentration of 5 wt%, and then chlorine (Cl), particularly chlorine ions ($Cl^-$), were extracted from the optical film. Specifically, 0.2 g of the optical film powder and 3.8 g of water were charged in a 20 mL vial, and sonication extraction was performed for 2 hours using a 5510 ultrasonic bath produced by Branson Ultrasonics. As a result, a chlorine extraction mixture containing chlorine (Cl) extracted from the optical film was prepared. The prepared chlorine extraction mixture was filtered through a 0.45 um nylon filter to prepare a sample for measurement. 20 μl of the sample for measurement was injected into an ion chromatograph device set at a column temperature of 30°C and a measurement cell temperature of 35°C, and then the area of the peak corresponding to the chlorine ions, among the separated ion peaks, was measured. In order to calculate the chlorine ion content, Dionex Seven Anion Standard from Thermo Scientific was diluted with distilled water to prepare standard chlorine ion solutions in a concentration range of 0.04 ppm to 1 ppm (0.04 ppm, 0.06 ppm, 0.08 ppm, 0.1 ppm, and 1.0 ppm), and ion chromatography analysis was performed on the standard chlorine ion solutions in the same manner as for the sample for measurement. A calibration curve was drawn by detecting the area of the peak corresponding to the chlorine ion measured using the standard solution.

The calibration curve is expressed as a primary function as shown in the following Equation 1:

[Equation 1]

$$y = ax + b$$

wherein y is the peak area, x is the concentration of the standard solution, a is the slope of the calibration curve, and b is the y-axis intercept of the calibration curve. By applying the calibration curve obtained in Equation 1 to the peak area (y) of the sample for measurement, the chlorine concentration (x) of the sample for measurement can be calculated. The chlorine concentration (x) of the sample for measurement can be obtained using the following Equation 2.

[Equation 2]

$$x = (y-b)/a$$

Next, the content of chlorine in the optical film is calculated in consideration of the dilution ratio applied to preparation of the sample for measurement. Specifically, the weight ratio of the optical film applied to the sample for measurement may be calculated using the following Equation 3:

Weight ratio of optical film in sample for measurement = (weight of optical film)/(weight of optical film + weight of distilled water) [Equation 3]

wherein "weight of optical film" means the weight of the optical film used to produce the sample for measurement.

Next, the chlorine concentration of the optical film is calculated in accordance with the following Equation 4 using the weight ratio of the optical film in the sample for measurement and the concentration of chlorine in the sample for measurement.

Chlorine concentration of optical film = (chlorine concentration in sample for measurement)/(weight ratio of optical film to sample for measurement) [Equation 4]

4) Yellowness index (Y.I.): The yellowness index was measured using a spectrophotometer (CM-3700D, KONICA MINOLTA) in accordance with the ASTM E313 standard.

5) Light transmittance (%): The average optical transmittance at a wavelength of 360 to 740 nm was measured using a spectrophotometer (CM-3700D, KONICA MINOLTA).

The measurement results are shown in Table 2 below.

[Table 2]

| Type | pH | | Number average molecular weight of resin | Chlorine content (ppm) | Yellowness index (Y.I.) | Light transmittance (%) |
|---|---|---|---|---|---|---|
| | Second reaction solution | Polymer resin solution | | | | |
| Example 1 | 8.2 | 6.8 | 215,000 | 110 | 2.4 | 90.2 |
| Example 2 | 8.4 | 6.7 | 196,300 | 105 | 2.8 | 88.9 |
| Example 3 | 8.6 | 6.7 | 180,530 | 115 | 3.1 | 89 |
| Example 4 | 8.7 | 6.5 | 204,930 | 118 | 3.2 | 89.3 |
| Example 5 | 8.7 | 6.6 | 230,586 | 93 | 3.2 | 88.8 |
| Example 6 | 8.3 | 6.5 | 225,016 | 85 | 2.3 | 90.5 |
| Example 7 | 8.5 | 6.3 | 179,538 | 101 | 3.5 | 88.9 |
| Example 8 | 8.5 | 6.7 | 198,760 | 93 | 3.2 | 89.2 |
| Example 9 | 8.4 | 6.4 | 168,960 | 114 | 3.7 | 89 |
| Comparative Example 1 | 6.9 | 6.8 | 146,850 | 1620 | 10.5 | 85.2 |
| Comparative Example 2 | 8.9 | 6.7 | 205,400 | 190 | 4.5 | 88.6 |
| Comparative Example 3 | 7.6 | 6.1 | 132,780 | 234 | 4.6 | 88.4 |
| Comparative Example 4 | 9.3 | 6.8 | 189,634 | 103 | 4.5 | 88.5 |
| Comparative Example 5 | 8.5 | 6.4 | 178,940 | 108 | 4.3 | 88.4 |
| Comparative Example 6 | 7.2 | 5.8 | 120,540 | 1860 | 4.7 | 88.1 |

As can be seen from the results of measurement of Table 1, in examples of the present disclosure, the pH of the second reaction solution was 8 or more, the pH of the polymer resin solution was 6 to 7, the number average molecular weight of the resin was 150,000 or more, the degree of polymerization was excellent, and the yellowness index and light transmittance were superior.

However, it can be seen that in Comparative Example 1, the pH of the second reaction solution was less than 8, the number average molecular weight of the resin was less than 150,000, the polymerization reaction was not sufficiently performed, and visibility was low due to the high yellowness and low light transmittance. In Comparative Example 2, the number average molecular weight was 205,400, indicating a high degree of polymerization, but the proportion of the dianhydride-based compound was high, so the yellowness index was high and the visibility was low. In Comparative Example 3, in which the amount of propylene oxide that was added was about 3.5 times the content of TPC based on the number of moles, the pH of the second reaction solution was less than 8, the number average molecular weight of the resin was less than 150,000, the polymerization reaction did not sufficiently progress, and the visibility was low due to the high yellowness index and low light transmittance. In Comparative Example 4, in which the amount of propylene oxide added was about 7.5 times the TPC content based on the number of moles, the pH of the second reaction solution

was greater than 9, the number average molecular weight of the resin was 189,634, and the degree of polymerization was excellent, but the visibility was low due to high yellowness. In Comparative Example 5, in which polymerization was performed using a dicarbonyl-based compound, a first diamine-based compound, and a second diamine-based compound without adding a dianhydride-based compound, the visibility was low due to the high yellowness index and low light transmittance. In Comparative Example 6, in which the amount of propylene oxide that was added was about 2.25 times the amount of TPC based on the number of moles and pyridine and acetic anhydride were added were about 1.1 times the content of 6FDA based on the number of moles, the pH of the second reaction solution was less than 8, the pH of the resin solution was less than 6.0, and the number average molecular weight of the resin was less than 150,000, indicating that polymerization did not sufficiently progress. In addition, it can be seen that visibility was poor due to the high yellowness index and low light transmittance.

[Explanation of reference numerals]

100: Optical film
200: Display device
501: Display panel

## Claims

1. An optical film comprising a polymer resin,

   the polymer resin comprising an imide repeating unit and an amide repeating unit,
   wherein the amide repeating unit is present in a proportion of 80% or more with respect to a total amount of the imide repeating unit and the amide repeating unit.

2. The optical film according to claim 1, wherein the optical film comprises 120 ppm by weight (0.012% by weight) or less of chlorine (Cl),
   wherein the concentration of chlorine is measured by performing ion chromatography analysis on a chlorine (Cl) extract obtained by freeze-drying and pulverizing the optical film and then extracting the film using distilled water.

3. The optical film according to claim 1, wherein the optical film comprises 50 ppm by weight (0.005% by weight) or less of chlorine (Cl).

4. The optical film according to claim 1, wherein the imide repeating unit comprises a first repeating unit and a second repeating unit,

   wherein the first repeating unit is an imide repeating unit formed by polymerization of a first diamine-based compound and a dianhydride-based compound, and
   the second repeating unit is an imide repeating unit formed by polymerization of a second diamine-based compound and the dianhydride-based compound.

5. The optical film according to claim 1, wherein the amide repeating unit comprises a third repeating unit and a fourth repeating unit,

   wherein the third repeating unit is an amide repeating unit formed by polymerization of a first diamine-based compound and a dicarbonyl-based compound, and
   the fourth repeating unit is an amide repeating unit formed by polymerization of a second diamine-based compound and the dicarbonyl-based compound.

6. The optical film according to claim 4 or 5, wherein the first diamine-based compound is an aromatic diamine-based compound, and
   the first diamine-based compound comprises at least one selected from the group consisting of 2,2'-bis(trifluoromethyl)benzidine (TFDB), 2,2-bis[4-(4-aminophenoxy)phenyl]hexafluoropropane (HFBAPP), bis[4-(4-aminophenoxy)phenyl]sulfone (BAPS), bis[4-(3-minophenoxy)phenyl]sulfone (BAPSM), 4,4'-diaminodiphenylsulfone (4DDS), 3,3'-diaminodiphenylsulfone (3DDS), para-phenylene diamine (pPDA), meta-phenylene diamine (mPDA), para-methylene dianiline (pMDA), meta-methylene dianiline (mMDA), 2,2-bis[4-(4-aminophenoxy)phenyl] propane (BAPP), 4,4'-diaminodiphenyl propane (6HDA), 1,3-bis(4-aminophenoxy)benzene (134APB), 1,3-bis(3-aminophenoxy)benzene (133APB), 1,4-bis(4-aminophenoxy)biphenyl (BAPB), 4,4'-bis(4-amino-2-trifluoromethylphenoxy)biphenyl (6FAPBP), 3,3-diamino-4,4'-dihydroxydiphenylsulfone (DABS), 2,2-bis(3-amino-4-hydroxyphenyl)propane (BAP), 4,4'-diaminodiphenylmethane (DDM), 4,4'-oxydianiline (4-ODA), 3,3'-oxydianiline (3-ODA), 2,2'-dimethyl-4,4'-(9-fluorenylidene)dianiline (MFDA), 9,9-bis(4-aminophenyl)fluorene (FDA) and 9,9-bis(3-fluoro-4-aminophenyl)fluorene (FFDA).

**7.** The optical film according to claim 4 or 5, wherein the second diamine-based compound is an aliphatic diamine-based compound, and
the second diamine-based compound comprises at least one selected from the group consisting of 4,4'-methylenebis cyclohexylamine (MBCA), 1,3-bis(aminomethyl)cyclohexane, 1,4-cyclohexanediamine, bicyclo [2.2.1]heptanebis(methylamine), and isomers of cis, trans and mixtures of the compounds.

**8.** The optical film according to claim 4, wherein the dianhydride-based compound comprises at least one selected from the group consisting of 2,2-bis(3,4-dicarboxyphenyl)hexafluoropropane dianhydride (6FDA), 4-(2,5-dioxotetrahydrofuran-3-yl)-1,2,3,4-tetrahydronaphthalene-1,2-dicarboxylic anhydride (TDA), 1,2,4,5-benzene tetracarboxylic dianhydride (pyromellitic dianhydride, PMDA), 3,3,4,4-benzophenone tetracarboxylic dianhydride (BTDA), 3,3,4,4-biphenyltetracarboxylic dianhydride (BPDA), 4,4-oxydiphthalic dianhydride (ODPA), bis(3,4-dicarboxyphenyl)dimethylsilane dianhydride (SiDA), 4,4-bis(3,4-dicarboxyphenoxy)diphenyl sulfide dianhydride (BDSDA), sulfonyldiphthalic anhydride ($SO_2$DPA), cyclobutane-1,2,3,4-tetracarboxylic dianhydride (CBDA), and 4,4'-(4,4'-isopropylidenediphenoxy)bis(phthalic anhydride) (6HBDA).

**9.** The optical film according to claim 5, wherein the dicarbonyl-based compound comprises at least one selected from the group consisting of phthaloyl chloride, terephthaloyl chloride (TPC), isophthaloyl chloride (IPC), 4,4'-biphenyldicarbonyl chloride (DPDOC), 4,4'-oxybis(benzoyl chloride) (OBBOC), and naphthalene-2,3-dicarbonyl dichloride.

**10.** The optical film according to claim 1, wherein the optical film has a yellowness index of 4.0 or less.

**11.** The optical film according to claim 1, wherein the optical film has a light transmittance of 88.50% or more.

**12.** A display device comprising:

a display panel; and
the optical film according to any one of claims 1 to 11 disposed on the display panel.

**13.** A method for manufacturing an optical film, the method comprising:

forming a first reaction solution using at least one of a first diamine-based compound and a second diamine-based compound, a dianhydride-based compound, a dicarbonyl-based compound, and a chlorine (Cl) acceptor;
adding a dehydrating agent and an imidization catalyst to the first reaction solution and allowing a reaction to occur therebetween to form a second reaction solution;
treating the second reaction solution to prepare a polymer resin in a solid phase;
dissolving the solid-phase polymer resin to prepare a polymer resin solution, and
casting the polymer resin solution,
wherein a content of the chlorine (Cl) acceptor is 4 to 7 times a content of the dicarbonyl-based compound based on a number of moles.

**14.** The method according to claim 13, wherein the first diamine-based compound is an aromatic diamine-based compound and the second diamine-based compound is an aliphatic diamine-based compound.

**15.** The method according to claim 13, wherein the content of the dicarbonyl-based compound is 80 to 99 parts by mole and the content of the dianhydride-based compound is 1 to 20 parts by mole with respect to 100 parts by mole of a total content of the first diamine-based compound and the second diamine-based compound.

**16.** The method according to claim 13, wherein the content of the first diamine-based compound is 85 to 95 parts by mole and the content of the second diamine-based compound is 5 to 15 parts by mole with respect to 100 parts by mole of the total content of the first diamine-based compound and the second diamine-based compound.

**17.** The method according to claim 13, wherein the chlorine (Cl) acceptor comprises a cyclic ether-based compound.

**18.** The method according to claim 17, wherein the cyclic ether-based compound comprises at least one of an epoxide-based compound, an oxetane-based compound, a tetrahydrofuran-based compound, and a tetrahydropyran-based compound.

**19.** The method according to claim 17, wherein the cyclic ether-based compound comprises a propylene oxide-based compound.

**20.** The method according to claim 13, wherein the second reaction solution has a pH of 8 to 9.

**21.** The method according to claim 13, wherein the polymer resin solution has a pH of 6 to 7.

FIG. 1

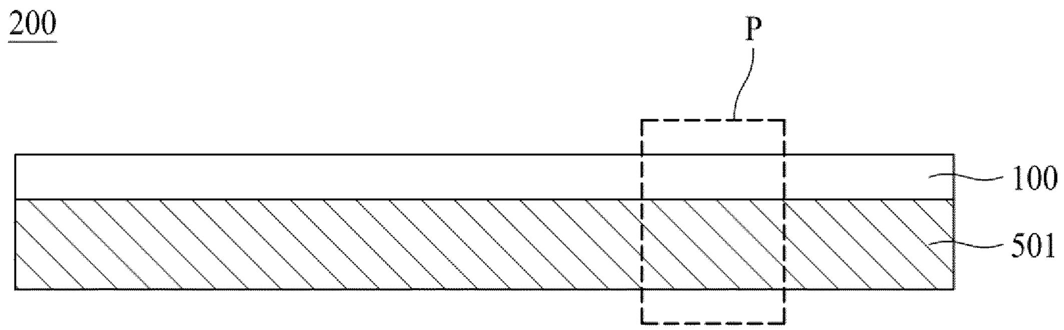
200
P
100
501

FIG. 2

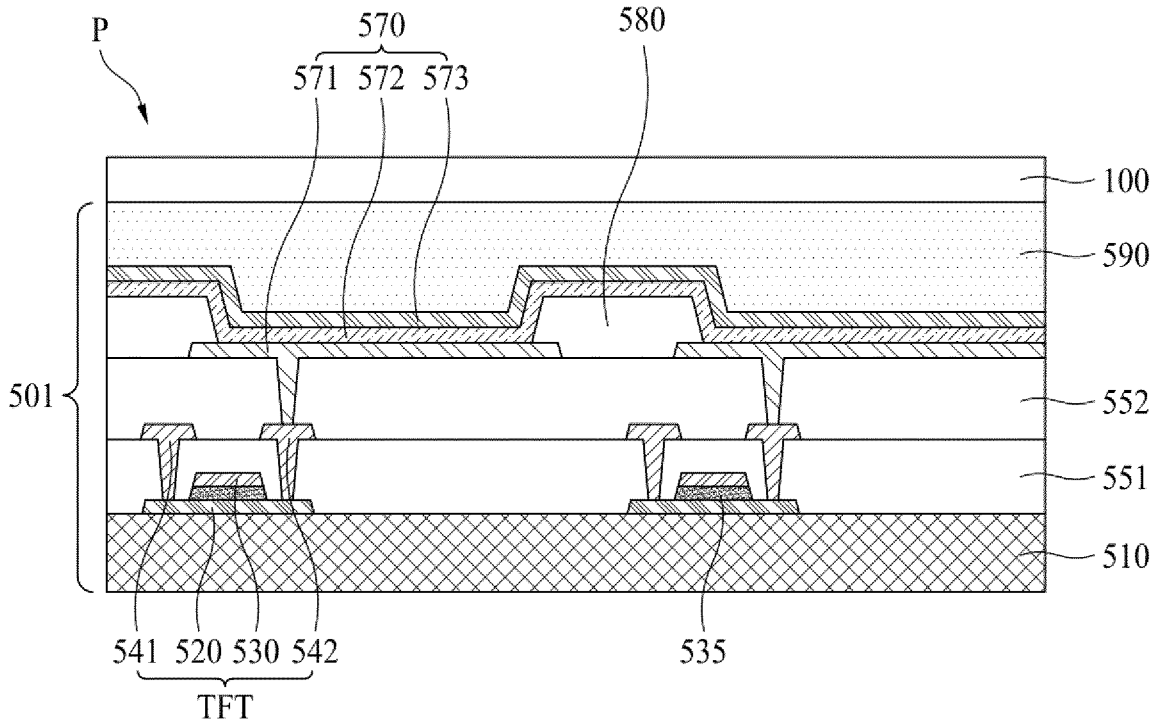
P
570
571 572 573
580
100
590
501
552
551
510
541 520 530 542
535
TFT

**INTERNATIONAL SEARCH REPORT**

International application No.
**PCT/KR2022/005983**

**A. CLASSIFICATION OF SUBJECT MATTER**

**C08J 5/18**(2006.01)i; **C08G 73/14**(2006.01)i; **C08L 79/08**(2006.01)i; **G02B 1/04**(2006.01)i

According to International Patent Classification (IPC) or to both national classification and IPC

**B. FIELDS SEARCHED**

Minimum documentation searched (classification system followed by classification symbols)

C08J 5/18(2006.01); B29C 48/08(2019.01); C08G 73/10(2006.01); C08G 73/14(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 폴리아마이드-이미드(poly(amide-imide)), 광학 필름(optical film), 제1디아민(first diamine), 제2디아민(second diamine), 디안하이드라이드 화합물(dianhydride compound), 디카르보닐계 화합물(dicarbonyl compound), 염소 수용체(chlorine receptor)

**C. DOCUMENTS CONSIDERED TO BE RELEVANT**

| Category* | Citation of document, with indication, where appropriate, of the relevant passages | Relevant to claim No. |
|---|---|---|
| X<br>A | KR 10-2019-0028140 A (SAMSUNG ELECTRONICS CO., LTD. et al.) 18 March 2019 (2019-03-18)<br>See paragraphs [0073], [0115], [0211] and [0212]; claims 1 and 12; and table 1. | 1,4-11<br>2,3,13-21 |
| X | KR 10-2020-0008006 A (SKC CO., LTD.) 22 January 2020 (2020-01-22)<br>See paragraphs [0005], [0021], [0044], [0047], [0185], [0206], [0209], [0236], [0243] and [0245]; claim 1; and table 2. | 1,10,11 |
| X | WO 2018-147617 A1 (SKC CO., LTD.) 16 August 2018 (2018-08-16)<br>See paragraphs [0007] and [0102]; and table 2. | 1,10,11 |
| A | KR 10-2019-0087397 A (KOLON INDUSTRIES, INC.) 24 July 2019 (2019-07-24)<br>See entire document. | 1-11,13-21 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **19 September 2022** | **19 September 2022** |
| Name and mailing address of the ISA/KR<br>**Korean Intellectual Property Office**<br>**Government Complex-Daejeon Building 4, 189 Cheongsa-ro, Seo-gu, Daejeon 35208**<br>Facsimile No. **+82-42-481-8578** | Authorized officer<br><br>Telephone No. |

Form PCT/ISA/210 (second sheet) (July 2019)

**INTERNATIONAL SEARCH REPORT**

International application No.
**PCT/KR2022/005983**

**C. DOCUMENTS CONSIDERED TO BE RELEVANT**

| Category* | Citation of document, with indication, where appropriate, of the relevant passages | Relevant to claim No. |
|---|---|---|
| A | WO 2017-204462 A1 (LG CHEM, LTD.) 30 November 2017 (2017-11-30)<br>See entire document. | 1-11,13-21 |

Form PCT/ISA/210 (second sheet) (July 2019)

**INTERNATIONAL SEARCH REPORT**

International application No.
**PCT/KR2022/005983**

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☑ Claims Nos.: **12**
because they are dependent claims and are not drafted in accordance with the second and third sentences of Rule 6.4(a).

Form PCT/ISA/210 (continuation of first sheet) (July 2019)

**INTERNATIONAL SEARCH REPORT**
**Information on patent family members**

International application No.
**PCT/KR2022/005983**

| Patent document cited in search report | Publication date (day/month/year) | Patent family member(s) | Publication date (day/month/year) |
|---|---|---|---|
| KR 10-2019-0028140 A | 18 March 2019 | JP 2019-048977 A | 28 March 2019 |
| | | KR 10-2430056 B1 | 05 August 2022 |
| | | US 11028227 B2 | 08 June 2021 |
| | | US 2019-0077916 A1 | 14 March 2019 |
| | | US 2021-0253796 A1 | 19 August 2021 |
| KR 10-2020-0008006 A | 22 January 2020 | KR 10-2019-0080397 A | 08 July 2019 |
| | | KR 10-2157705 B1 | 18 September 2020 |
| WO 2018-147617 A1 | 16 August 2018 | JP 2020-505486 A | 20 February 2020 |
| | | JP 6982620 B2 | 17 December 2021 |
| | | KR 10-1831884 B1 | 26 February 2018 |
| | | KR 10-1890898 B1 | 22 August 2018 |
| | | KR 10-1908121 B1 | 15 October 2018 |
| | | KR 10-2018-0092258 A | 17 August 2018 |
| | | KR 10-2018-0092259 A | 17 August 2018 |
| | | KR 10-2018-0092266 A | 17 August 2018 |
| | | KR 10-2018-0092297 A | 17 August 2018 |
| | | KR 10-2018-0092300 A | 17 August 2018 |
| | | KR 10-2020-0092917 A | 04 August 2020 |
| | | KR 10-2174372 B1 | 04 November 2020 |
| | | US 11306183 B2 | 19 April 2022 |
| | | US 2019-0359772 A1 | 28 November 2019 |
| KR 10-2019-0087397 A | 24 July 2019 | JP 2017-503887 A | 02 February 2017 |
| | | JP 6244470 B2 | 06 December 2017 |
| | | KR 10-1870341 B1 | 22 June 2018 |
| | | KR 10-2015-0076114 A | 06 July 2015 |
| | | KR 10-2018-0068941 A | 22 June 2018 |
| | | KR 10-2238308 B1 | 09 April 2021 |
| | | US 2016-0319076 A1 | 03 November 2016 |
| | | US 9580555 B2 | 28 February 2017 |
| WO 2017-204462 A1 | 30 November 2017 | JP 2019-505604 A | 28 February 2019 |
| | | JP 6862652 B2 | 21 April 2021 |
| | | KR 10-2017-0132459 A | 04 December 2017 |
| | | KR 10-2080962 B1 | 23 April 2020 |
| | | US 2019-0016849 A1 | 17 January 2019 |

Form PCT/ISA/210 (patent family annex) (July 2019)